# EUROPÄISCHE PATENTANMELDUNG

(11) **EP 1 093 880 A1**
(43) Veröffentlichungstag der Anmeldung: **25.04.2001**
(21) Anmeldenummer: 99121031.1
(22) Anmeldetag: 21.10.1999
(51) Int. Cl.: B23K 1/005

(54) **Verfahren und Vorrichtung zum selektiven Erwärmen von Bauelementen**

(71) Anmelder: Leister Process Technologies, 6060 Sarnen (CH)
(72) Erfinder: Chen, Jie-Wei, 6055 Alpnach Dorf (CH); Leister, Christiane, 6063 Stalden (CH)
(74) Vertreter: Klocke, Peter, Dipl.-Ing.

(57) **Zusammenfassung**

Verfahren und Vorrichtung zur Verbindung oder Trennen von mindestens zwei Bauelementen mittels Laserstrahlung, wobei zwischen der Laserquelle und den Erwärmungsbereichen der Bauelemente eine Maske aus einem laserstrahlundurchlässigen Material angeordnet wird, bei der die Erwärmungsbereiche ausgenommen sind. Alle Erwärmungsbereiche werden mittels variabler Laserstrahlen gleichzeitig erwärmt und miteinander verbunden, wobei der Laserstrahl relativ zu der Maske bewegt wird und umgekehrt. Dieses Verfahren und die Vorrichtung erlaubt das kostengünstige, schnelle und präzise Verbindung und Entfernen von Bauelementen insbesondere mit metallischen Anschlüssen auf einer Leiterplatte, wobei gleichzeitig eine universelle Anpassung bei Veränderung der Abmessungen möglich ist.

## Beschreibung

Die vorliegende Erfindung betrifft ein Verfahren zum Erwärmen von mindestens zwei Bauelementen mittels Laserstrahlen, um die Bauelemente entweder miteinander zu Verbinden oder auch zu Trennen. Sie betrifft außerdem eine Vorrichtung zur Durchführung des Verfahrens.

Beim Aufbringen oder Entfernen beipielsweise von SMD-Halbleiterbauelementen (Surface Mount Device) auf einem Träger ist es bekannt, diese mittels Laserstrahlen mit den Leiterzügen auf oder in einer Leiterplatte zu erwärmen. Die Verbindung kann dabei mittels eines Lotes oder auch nur durch entsprechende Erwärmung der Fügepartner ohne Lot erfolgen (sog. Mikrofügen). Die Erwärmung der Füße der Halbleiterbauelemente sowie der entsprechenden Stelle auf der Leiterplatte erfolgt teilweise bereits mittels eines punktuellen Laserstrahls, wobei dieser entweder von einem Lötpunkt zum nächsten wandert oder in dem mehrere Laserquellen eingesetzt werden, die gleichzeitig die Verbindungsstellen erwärmen.

In der US 5 196 667 wird eine Einrichtung zum Ver- und Entlöten von elektronischen Bauelementen beschrieben, bei der ein heißer Gasstrom oder IR-Strahlung auf die Verbindungen der Bauelemente gerichtet wird, wobei eine Maske verwendet wird, die Öffnungen aufweist, die genau der zu schweißenden Konfiguration entsprechen. Zum Schutz der Maske vor der Wärmestrahlung sind zusätzlich Schilder mit geringer Wärmeleitfähigkeit vorgesehen. Der Abstand der Maske von der Wärmequelle sowie die Stellung der Maskenöffnung gegenüber der Wärmequelle kann verändert werden.

Aus der EP 0 315 228 B1 ist bekannt, elektronische Bauelemente mit einem Träger zu verlöten, indem die Lötverbindungen mittels einer Wärmequelle, beispielsweise Warmluftstrahl und/oder Infrarotstrahl bestrahlt werden. Zur Begrenzung dieses Strahls ist eine Maske mit Abstand von der Wärmequelle angeordnet, die Ausnehmungen aufweist, die den zu verlötenden Anschlußflächen entsprechen.

Aus der Veröffentlichung "Laserstrahlunterstützes Reflow-Löten für räumlich spritzgegossene Schaltungsträger (3-D MID)" der Universität Erlangen von Thomas Fröhlich, Stefan Hierl und Wolfgang Hirt, 1997 ist bekannt, Laserstrahlen zum Löten von SMDs zu verwenden, wobei auch Lichtlinien verwendet werden, deren Linienlänge verschiedenen Bauelementgrößen angepaßt werden kann. Als Strahlenquelle werden dort u.a. Diodenlaser angegeben, wobei eingeräumt wird, daß die Laseranwendung die klassischen Massenlöttechniken nicht ersetzen kann.

Der vorliegenden Erfindung liegt die Aufgabe zugrunde, eine verbesserte Möglichkeit vorzuschlagen, mit der eine Erwärmung zum Zwecke der Verbindung oder Trennung von mindestens zwei Bauelementen gleicher oder unterschiedlicher Materialien, auch Metall, Legierungen, Kunststoff, Keramik, organische oder nicht organische Substanzen erzielt werden kann und die auch den Einsatz in Großserien erlaubt.

Diese Aufgabe wird erfindungsgemäß durch ein Verfahren mit den Merkmalen des Hauptanspruchs gelöst. Weitere vorteilhafte Ausgestaltungen sind den Unteransprüchen zu entnehmen.

Gemäß dem Verfahren wird zwischen der Laserquelle und den Bauelementen eine Maske aus einem laserstrahlundurchlässigen Material angeordnet, bei der die zu verbindenden Bereiche ausgenommen sind. Alle Erwärmungsbereiche werden dann mittels eines oder mehrerer Laserstrahlen einzeln oder gleichzeitig betrahlt, so daß die Erwärmungsbereiche der Bauelemente erwärmt und miteinander verbunden oder getrennt werden. Dabei kann, je nach Anwendungsfall und Wirtschaftlichkeit der dazu einzusetzenden Anordnung, ein linienförmiger oder punktförmiger Laserstrahl gewählt werden, der sich relativ zu den Bauelementen und dem Träger bewegt. Die Relativbewegung zwischen dem Laserstrahl und den Bauelementen kann bei feststehendem Laserstrahl mittels eines Bewegungselements durch Verfahren der Bauelemente zusammen mit der Maske bewirkt werden. Insbesondere bei kleineren zu erwärmenden Flächen kann bei feststehenden Bauelementen eine entsprechende Bewegung der Laserquelle parallel zur Maskenebene durchgeführt werden.

Gemäß einer besonders bevorzugten Ausführungsform kann die Relativbewegung insbesondere bei der simultanen Verbindung mehrerer Bereiche der Komponenten durch um eine, vorzugsweise parallel zum Träger verlaufende Achse schwenk- oder drehbare Spiegel oder andere geeignete Einrichtungen erzeugt werden. Dies ist beispielsweise besonders vorteilhaft bei dem Ein- und Entlöten von SMD-Bauelementen. Bei der Verwendung eines im Querschnitt länglichen Laserstrahls mit vorzugsweise einer Gesamtlinienlänge in einer Linie, die mindestens der Gesamtlänge des jeweiligen Erwärmungsbereichs (z.B. Anschlußflächenreihe eines elektronischen Bauelements auf einem Träger) entspricht, können gleichzeitig mehrere Erwärmungsbereiche bestrahlt und erwärmt werden, was sich durch eine besonders hohe Verbindungsgeschwindigkeit auszeichnet. Ein ggf. vorgesehener Verbindungsstoff, beispielsweise Lot, zwischen den Bauelementen (z.B. Anschlüssen und dem Trägermaterial) wird dabei selbstverständlich mit erwärmt. Die Erzeugung der Linie kann auch in bekannter Weise bei einem punktförmigen Laserstrahl durch entsprechende schnelle Bewegung eines Spiegels erzeugt werden.

Mittels dieses Verfahrens ist es somit möglich, mit hoher Taktgeschwindigkeit und einfacher Anpassung auf verschiedene Abmessungen der Bauelemente, jedoch variabel an verschiedene Anforderungen, ein Verbinden vorzunehmen, da die an mehreren Stellen (gleichzeitig) präzise fixiert oder getrennt werden können. Dies ist insbesondere bei der Anwendung des Verfahrens zum Verbinden und Trennen von Bauelementen (Halbleiterbauelementen) mit metallischen Anschlüssen von Vorteil. Vor allem ist eine aufwendige Steurung für die Relativbewegung zwischen der Laserquelle und den Erwärmungsbereichen, um diese genau zu treffen, nicht mehr erforderlich. Die Präzision beim Justieren liegt nur an der Maske und ihrer Qualität, wobei komplizierte optische Systeme nicht erforderlich sind. Durch einfachen Maskenwechsel können verschieden Abmessungen and Verbindungsflächengeometrien angepaßt werden. Des weiteren beseitigt die Maske die immer vorhandene Gefahr der unerwünschten Erwärmung des Trägers (Platine) und des elektronischen Bauelements beim Löten von Halbleiterbauelementen. Es können durch das erfindungsgemäße Verfahren die Baukosten für eine entsprechende Anlage ebenfalls erheblich reduziert werden. Durch die Verwendung eines Halbleiterlasers mit entsprechender Optik kann beispielsweise auf einfache Weise ein vorhangartiger Laserstrahl mit einem länglichen Querschnitt erzeugt werden, wobei dieser längliche Querschnitt im wesentlichen über den gesamten Abstandsbereich zwischen Laserquelle und Maske bzw. Anschlüsse vorhanden ist. Die gewünschte Länge des Laserlinie auch durch Anordnen mehrer Halbleiterlaser in einer Reihe erreicht werden kann.

Es kann auch, um eine unnötige Bestrahlung nicht zu erwärmender Bereiche zu vermeiden und zusätzlich den Einsatz einer Universalmaske zu ermöglichen, die Maske in jedem Erwärmungsbereich mit einer Linienbreite des Laserstrahls bestrahlt werden, die im wesentlichen der Breite der entsprechenden Öffnungen in der Maske entspricht.

Besonders vorteilhaft ist, wenn in Abhängigkeit der maximalen Leistung der Laserquelle zur Erwärmung der Verbindung auf die erforderliche Verbindungstemperatur die Taktzeit, innerhalb der die Anschlüsse eines Halbleiterbauelements bestrahlt werden, möglichst kurz gehalten wird. Dies kann entweder durch eine entsprechend schnelle Bewegung des Laserstrahls oder durch entsprechd kurzes Belichten erfolgen. Durch die kurze Erwärmung mit möglichst hoher Energie wird ein Ableiten der Wärme in die Beinchen des Halbleiterbauelements verhindert und darüber hinaus der gesamte Bearbeitungsprozeß forciert.

Zur Erzielung der notwendigen Verbindungstemperatur kann aufgrund der Verwendung eines Halbleiterlasers der Abstand bei im wesentlichen gleicher Linienbreite des Laserstrahls verändert werden. Dies ermöglicht eine leichte Anpassung an Veränderungen in der erforderlichen Erwärmungstemperatur. Durch einen trapezförmigen Laserstrahl, wie er durch entsprechende Optik bei einem Halbleiterlaser ausbildbar ist, kann leicht die Linienlänge beeinflußt und auf geänderte Abmessungen eingestellt werden. Dies kann derart erfolgen, daß die sog. schnelle axiale Richtung der von einem Halbleiterlaser erzeugten Strahlen kollimiert und in der sog. langsamen axialen Richtung die Strahlen mit kleinem Divergenzwinkel umgeformt werden. Die maximale Länge der Laserstrahllinie auf der Maske ergibt sich aus der maximalen Länge des Erwärmungsbereichs.

Es kann gemäß einer weiteren vorteilhaften Ausgestaltung des Verfahrens durch Abstandsveränderung zwischen zwei um 90° gedrehten Zylinderlinsen, die zwischen der Laserquelle und der Maske angeodnet sind, die Laserlänge beeinflußt werden (Zoom-Optik). Dabei wird unabhängig von der Linienlänge die volle zur Verfügung stehende Energie ausgenutzt. Zusätzlich oder alternativ können mittels einer geeigneten Optik gleichzeitig mehrere Laserpunkte erzeugt werden, die in ihren Abständen den zugehörigen ausgenommenen Bereichen der Maske entsprechen. In diesem Fall wird die Maske maximal nur im Bereich der jeweiligen Ausnehmung in der Maske erwärmt. Dies hat den Vorteil der vollen Energieausnutzung mit möglichst geringem Verlust durch die Maske.

Gemäß einer besonders bevorzugten Ausführungsform des Verfahrens wird eine Maske mit Gruppen von Öffnungen, die den Erwärmungsbereichen gleicher und/oder verschiedener Bauelemente entsprechen, verwendet und die jeweils die zu verbindenden Bauelemente betreffenden Öffnungen werden bestrahlt. Somit wird eine einzelne Maske für verschiedene Bauelementgrößen verwendet und es werden beispielsweise die zu dem jeweiligen Bauelement gehörenden parallelen Reihen mittels eines schmalen linienförmigen Laserstrahls gleichzeitig bestrahlt. Dies kann je nach Bauelement unterschiedlich sein und alle vier Seiten eines rechteckförmigen Bauelements oder auch einzelne gesonderte Bauelemente betreffen. Es ist somit eine gezielte Auswahl mit einer Universalmaske möglich.

Die Aufgabe wird außerdem durch eine Vorrichtung mit den Merkmalen des Anspruchs 9 gelöst. Weitere vorteilhafte Ausgestaltungen sind den darauf rückbezogenen Unteransprüchen zu entnehmen.

Die Vorrichtung umfaßt eine Laserquelle oberhalb der Maske, wobei zur Relativbewegung zwischen der Laserquelle und den Bauelementen entweder der Laserstrahl über mindestens einen schwenk- oder drehbarer Spiegel oder einer anderen geeigneten Umlenkeinrichtung umgelenkt wird, der über der Maske angeordnet und mittels eines Antriebs betätigbar ist, oder die Laserquelle an einem linearen Bewegungselement angeordnet ist, das mittels eines Antriebs parallel zur Maskenebene bewegbar ist, wobei in beiden Fällen die Bauelemente feststehen. Zusätzlich kann die Vorrichtung zur wahlweisen Betätigung ein Bewegungselement aufweisen, an dem die Bauelemente zusammen mit der Maske bei feststehendem Laserstrahl angeordnet sind, das mittels eines Antriebs senkrecht zum Laserstrahl bewegbar ist. Eine derartige Vorrichtung gestattet somit je nach Bedarf die Auswahl der Relativbewegung zwischen Laserquelle und Bauelementen in einer Einheit.

In einer bevorzugten Ausbildung der Vorrichtung ist zwischen dem Spiegel und der Maske ein Optiksystem zur Formung des Laserstrahls angeordnet. So kann eine Zylinderlinse vorgesehen sein, die den Laserstrahl zentriert. Diese dient dazu, daß die Laserstrahlung nach der Linse ständig senkrecht auf die Maske trifft. Dadurch kann die Distanz zwischen Spiegel und Maske wesentlich verkürzt werden. Ohne Zylinderlinse wird eine gewisser minimaler Abstand zwischen Spiegel und Maske gefordert, um den unerwünschten Winkeleffekt zu vermeiden.

Gemäß einer weiteren Ausbildung weist das Optiksystem eine erste Zylinderlinse und eine zweite, um 90° gedrehte Zylinderlinse auf, deren Abstand zueinander variiert werden kann. Mittels dieser Zoom-Optik können unterschiedliche Laserlängen erzeugt und der Laserstrahl auf der Maske fokussiert und defokussiert werden. Trotz unterschiedlicher Laserlinienlängen wird dabei die volle zur Verfügung stehend Energie ausgenutzt.

Zur Erwärmung nur einzelner Punkte weist das Optiksystem gemäß einer anderen Ausbildung eine Beugungsoptik auf, die mehrere Laserpunkte erzeugt. Die Beugungsoptik besteht vorzugsweise aus einer um 90° zu der ersten Zylinderlinse gedrehten Beugungslinse, die die Laserlinie in einzelne Laserpunkte umwandelt. Diese Laserpunkte, deren Abstand den zugeordneten Ausnehmungen in der Maske entsprechen sollte, werden auf die zugeordneten punktförmigen Ausnehmungen in der Maske gerichtet. Dadurch wird in diesen Bereichen nur eine minimale Erwärmung der Maske bewirkt, so daß kein Verlust durch die Maske eintritt und die volle zur Verfügung stehende Energie ausgenutzt wird.

Nachfolgend wird die Erfindung anhand von Ausführungsbeispielen in Verbindung mit den begleitenden Zeichnungen näher erläutert. Es stellen dar:
- Figur 1: eine prinzipiell perspektivische Darstellung einer Vorrichtung zum Verbinden von Bauelementen mit metallischen Anschlüssen an eine Leiterbahn,
- Figur 2: eine prinzipielle perspektivische Darstellung einer Vorrichtung mit einer universell einsetzbaren Maske,
- Figur 3: eine prinzipielle perspektivische Darstellung einer Vorrichtung mit einem Umlenkspiegel und einem linienförmigen Laserstrahl (a), einem linienförmigen Laserstrahl nach (a) mit einer Zoom-Optik (b), und mehreren punktförmigen Laserstrahlen (c),
- Figur 4: einen linienförmigen Strahl oder durch einen bewegten Punkt erzeugten linienförmigen Strahl zur gleichzeitigen Erwärmung verschiedener Verbindungsarten, und
- Figur 5: eine prinzipielle Darstellung einer Vorrichtung, die wahlweise die Bewegung des Laserstrahls bei feststehenden Bauelementen durch Bewegen der Laserquelle bzw. des Laserstrahls mittels Umlenkspiegel oder die Bewegung der Bauelemente zusammen mit der Maske erlaubt.

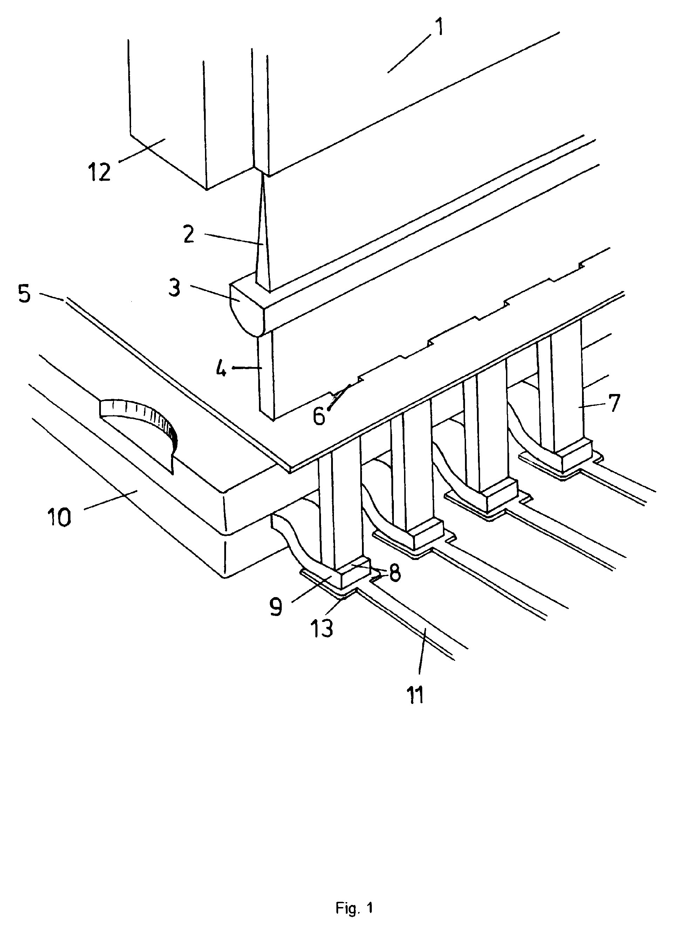

In Figur 1 ist eine Laserquelle 1, beispielsweise ein oder mehrere in Linie angeordnete Halbleiterlaser (Diodenlaser) angeordnet, deren emittierte Laserstrahlung 2 mit einer entsprechenden Optik 3 (z.B. Linsen) kollimiert oder fokussiert wird. Der von der Optik veränderte Laserstrahl 4 gelangt auf die Oberfläche einer laserstrahlundurchlässigen Maske 5 mit Öffnungen 6 über der Erwärmungsfläche 8 der Beinchen 9 eines SMD-Halbleiterbauelements 10. Die Maske 5 kann beispielsweise aus einem dünnen Metallblech oder aus einer auf einen stabilen durchsichtigen Träger aufgedampften Metallschicht bestehen. Durch die Öffnungen 6 gelangt dadurch nur ein Teil 7 des Laserstrahls 4 und erwärmt die Beinchen 9 im Bereich der Erwärmungsfläche 8 sowie die darunterliegende Anschlußfläche 13 der Leiterbahn 11. Die Leiterplatte 19 als Träger, auf der sich das Halbleiterbauelement 10, die Leiterbahn 11 sowie die Anschlußfläche 13 befinden, ist in dieser Figur nicht dargestellt.

Mindestens eine entsprechende Anordnung befindet sich üblicherweise auch an der gegenüberliegenden Seite des SMD-Halbleiterbauelements 10, so daß eine gleichzeitige Verbindung und Trennung aller Beinchen 9 mit der Anschlußfläche 13 der Leiterbahn 11 erfolgen kann. Die Steuerung 12 sorgt dafür, daß ein gleichzeitiges Takten der Laserquellen erfolgt. Selbstverständlich kann auch mit nur einer Laserquelle 1 gearbeitet werden, wobei durch eine entsprechende Optik die benötigte Anzahl weiterer Laserstrahllinien erzeugt wird. Damit ist auf jeden Fall die Gleichzeitigkeit beim Bestrahlen gewährleistet.

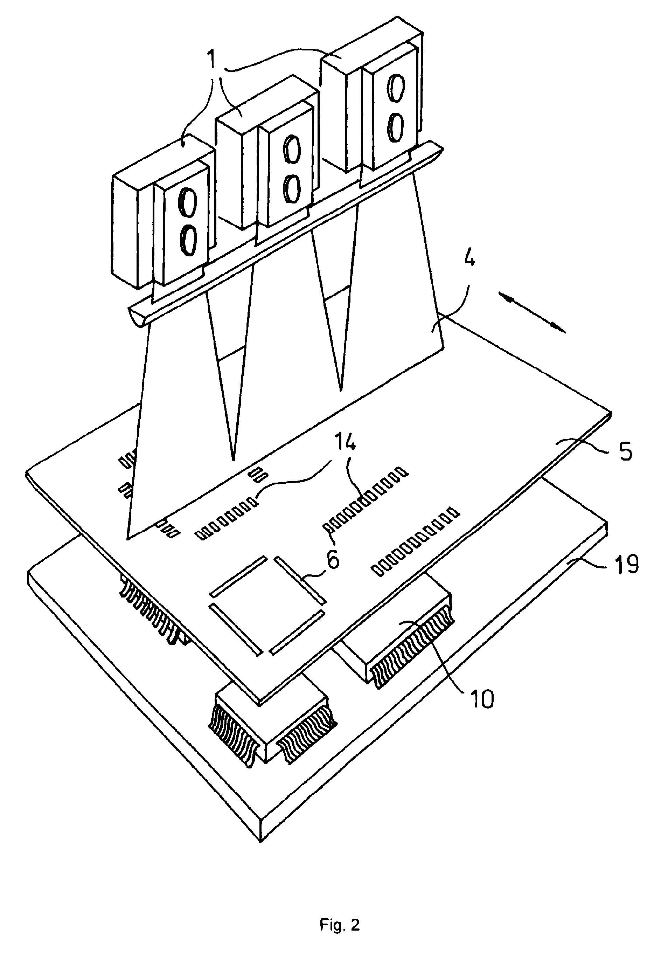

Figur 2 zeigt eine Maske 5 mit Gruppen 14 mit verschiedenen Öffnungen 6, hier beispielhaft als Reihe dargestellt, die den jeweiligen Erwärmungsflächen der elektronischen Komponente 10 entsprechen. Wie aus der Figur ersichtlich kann mit einer Maske eine Vielzahl verschiedener Bauelementgrößen oder -formen bearbeitet werden, weil der die Erwärmung bewirkende Laserstrahl immer nur auf die zu dem jeweiligen Bauelement gehörende Gruppe gerichtet wird.

In der Figur 2 sind beispielhaft drei Laserquellen 1 in Reihe dargestellt, die den linienförmigen Laserstrahl 4 auf die Maske 5 richten. Zwischen Laserstrahl 4 und Maske 5 findet, wie mittels Pfeilen angedeutet, eine Relativbewegung statt. Diese Anwendung eignet sich besonders bei der Bestückung von großen Platinen als Träger 19, um eine Vielzahl verschieder Bauelemente (SMT) auf der Platine zu verlöten oder zu entlöten.

Als Laserquelle werden Laser mit einer Wellenlänge von 0,7 - 10,6 um eingesetzt. Die erforderliche Leistung richtet sich nach der notwendigen Erwärmungstemperatur für den Verbindungsvorgang sowie die zu erzeugende Linienlänge. Die Prozeßführung beim Löten und Entlöten erfolgt in der an sich bekannten Art und Weise. Dabei können die Teile beispielsweise vorgewärmt und dann der abschließende Löt- oder Entlötvorgang mit dem Laserstrahl durchgeführt werden.

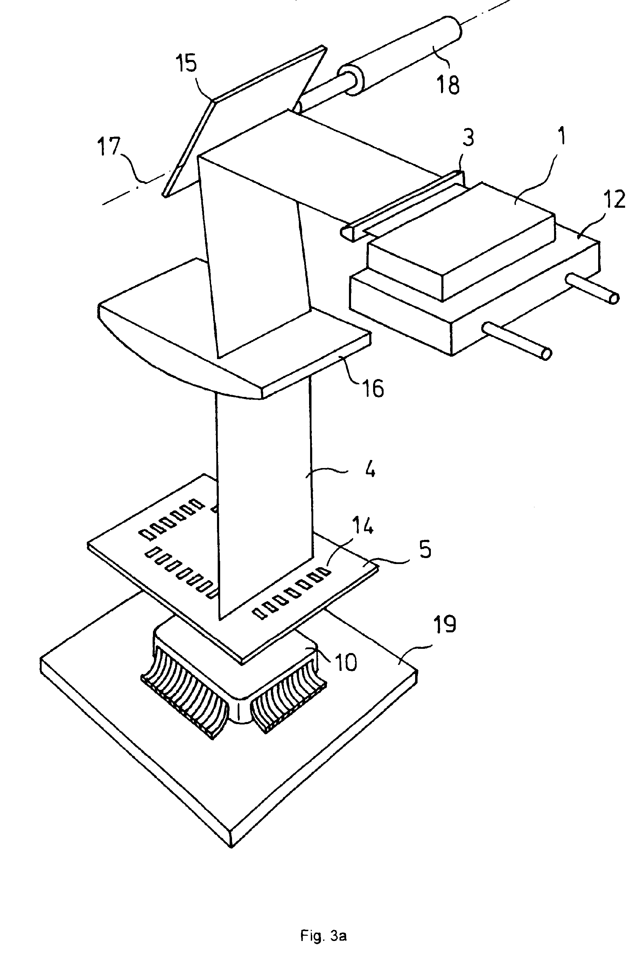

Figur 3a zeigt den prinzipiellen Aufbau einer Vorrichtung mit einem um eine Achse 17 parallel zum Bauelement 10 und Leiterplatte 19 angeordneten Spiegel 15. Der Spiegel 15, der mittels eines Antriebs 18 sehr schnell verstellt werden kann, bewirkt die Bewegung des Laserstrahls 4 über die Maske 5. Dieses Verfahren und diese Vorrichtung erlauben eine hohe Bestrahlungsgeschwindigkeit und Taktzeit, ohne daß aufwendige Bewegungsmechanismen, z.B. Lineartisch, insbesondere bei kleinen Abmessungen, einzelnen zu verbindenden Komponenten oder simultanen Löten und Entlöten erforderlich sind. Hierzu wird die Laserquelle 1 ebenfalls oberhalb der Fügepartner angeordnet und ein vorhangähnlicher Laserstrahl 4, wie bereits in Figur 1 dargestellt, mit einer geringen Linienbreite erzeugt. Dies erfolgt in bekannter Art und Weise derart, daß die sog. schnelle axiale Richtung der von einem Halbleiterlaser erzeugten Strahlen kollimiert und in der sog. langsamen axialen Richtung die Strahlen mit kleinem Divergenzwinkel umgeformt werden. Die maximale Länge der Laserstrahllinie in der Erwärmungsfläche 8 ergibt sich aus der maximalen Länge des Fügebereichs. Durch die Veränderung des Arbeitsabstandes kann die Länge dieser Laserlinie an die Länge der Anschlußflächenreihe 14 angepaßt werden. Durch Änderung der Leistung der Laserquelle erfolgt dann eine Anpassung an die minimale erforderliche Verbindungstemperatur. Zusätzlich ist noch eine Zylinderlinse 16 in dem Strahlengang angeordnet, die dafür sorgt, daß die Laserstrahlung nach der Linse ständig senkrecht auf die Maske 5 auftrifft.

Die Bewegung des Umlenkspiegels 15 kann entweder langsam erfolgen, so daß die gesamte zu erwärmende Fläche einmal überstrichen wird, oder sehr schnell (mindestens 100mal pro Sekunde), so daß für die bestrahlte Fläche die Bestrahlung wie eine andauernde, unterbrechungsfreie Bestrahlung wirkt.

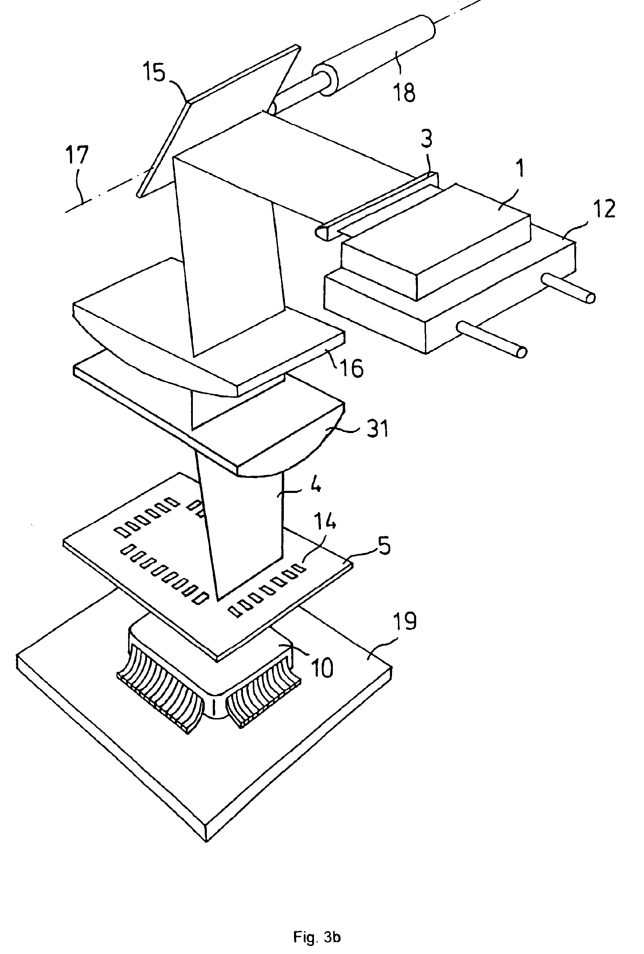

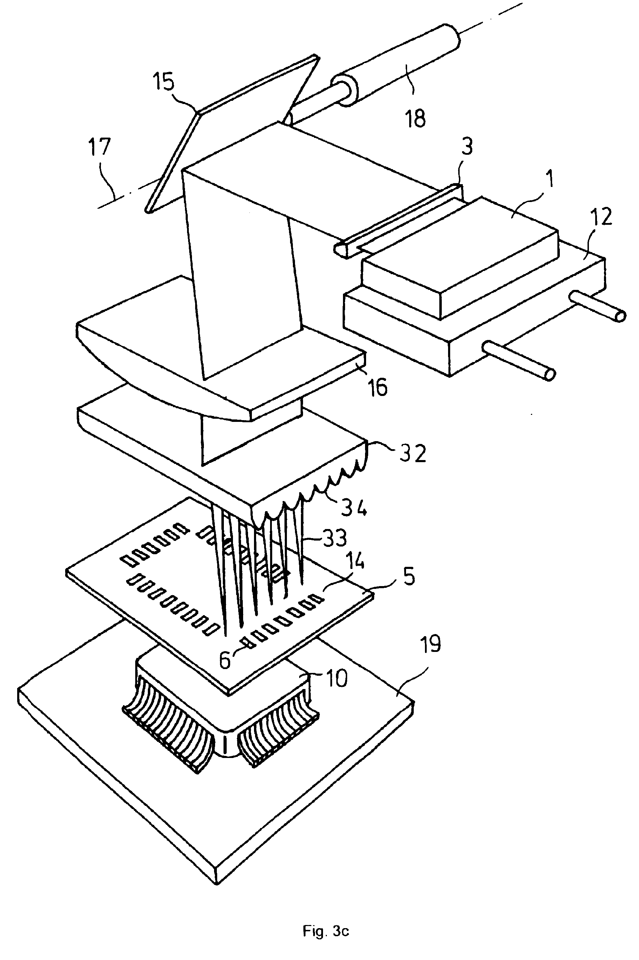

Figur 3b zeigt die Anordnung gemäß Figur 3a mit einer zusätzlichen Zylinderlinse 31, die um 90° gedreht ist. Mittels dieser Zoom-Optik kann durch Abstandsänderung zwischen den Linsen 16 und 31 verlustfrei die Länge der Laserlinie des Laserstrahls 4 eingestellt werden.

Gemäß der Ausführung in Figur 3c ist eine Beugungsoptik in Form einer Beugungslinse 32 vorgesehen, die ebenfalls gegenüber der Zylinderlinse 16 um 90° gedreht ist. Durch die Ausbildung der Beugungslinse 32 mit konvexen Bereichen 34 erzeugt diese aus einer Laserstrahllinie punktförmige Laserstrahlen 33, die auf die entsprechenden Öffnungen 6 in der Maske 5 gerichtet werden.

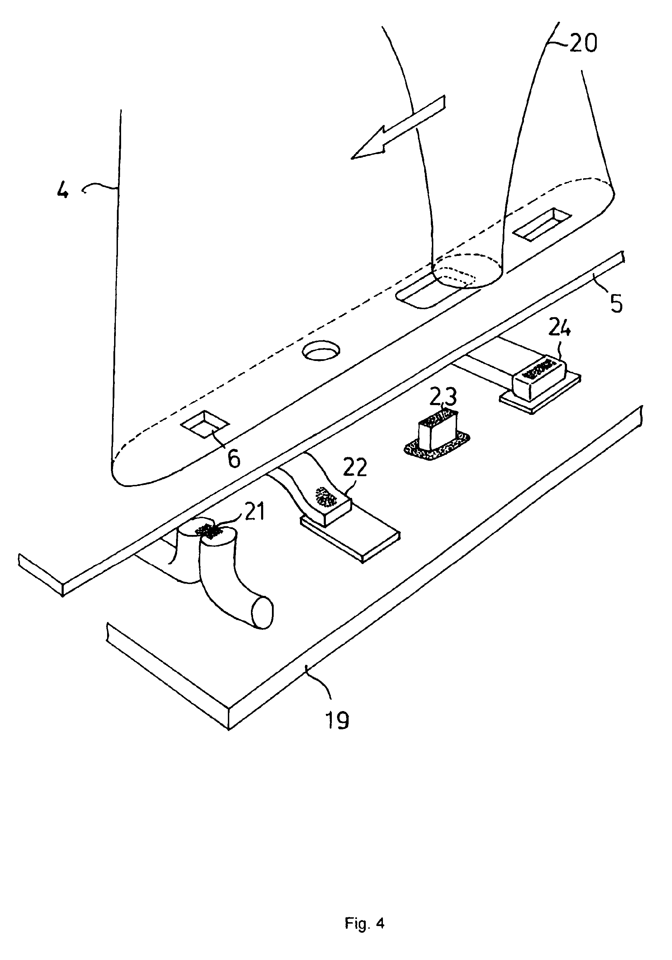

In Figur 4 bestrahlt ein linienförmiger Laserstrahl 4 oder ein punktförmiger Laserstrahl 20, der mit einer entsprechenden Geschwindigkeit bewegt wird, verschieden ausgestaltete Öffnungen 6 in einer Maske 5. Unterhalb der Maske 5 sind verschiedene Arten von Verbindungen im Prinzip gezeigt. Die Verbindung 21 stellt eine reine metallische Verbindung, die Verbindung 22 und 24 eine Verbindung zwischen einem aktiven bzw. passiven Halbleiterbauelement und einem Träger, und die Verbindung 23 eine Durchsteckverbindung dar.

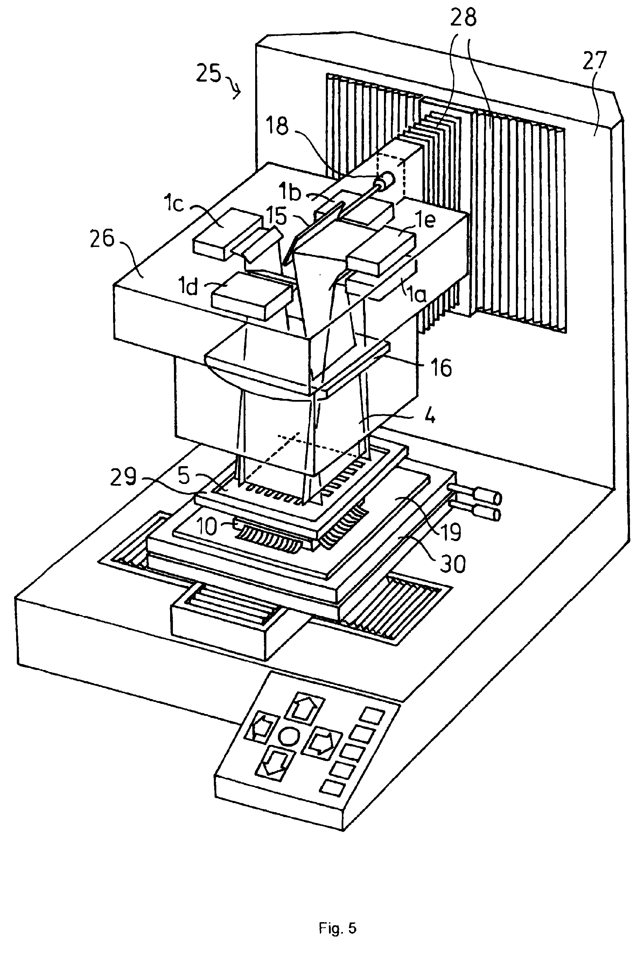

Figur 5 zeigt schematisch eine Vorrichtung 25, beispielsweise zum Löten und Entlöten, in der sowohl eine Einrichtung zum Bewegen des Laserstrahls bei feststehenden Bauelementen 10 und Träger 19 als auch eine Einrichtung zur Bewegung der zu verbindenden Teile 10, 19 mit Maske 5 dargestellt. Die Vorrichtung weist einen Laserkopf 26 an einem linearen Bewegungelement 28 auf, das in x-y-Richtung mittels eines geeigneten Antriebs 27 bewegbar ist. In dem Laserkopf 26 sind vier Diodenlaserquellen 1a - 1d angeordnet, vier linienförmige Laserstahlen als Rechteck auf die Maske 5 richten. Alternativ ist in dem Laserkopf 26 nur eine Laserquelle 1e mit einem mittels eines Antriebs 18 beweglichen Umlenkspiegel 15 angeordnet, die auf der Maske 5 über eine Zylinderlinse 16 eine bewegliche Laserlinie 4 erzeugt. Die Maske 5 wird von einem Maskenträger 29 gehalten, der mit einer in x-y-Richtung beweglichen Auflagefläche 30 verbunden ist. Die Maske 5 mit den zu verbindenden Bauelementen sind aufeinander ausgerichtet und in der Lage fixiert.

## Patentansprüche

1. Verfahren zum selektiven Erwärmen von mindestens zwei Bauelementen (10, 19) mittels Wärmestrahlen (4), wobei zwischen der Strahlenquelle (1) und den Bauelementen (10) eine Maske (5) aus einem strahlundurchlässigen Material angeordnet wird, bei der Bereiche (6) ausgenommen sind, durch die die Wärmestrahlung auf selektierte Erwärmungsbereiche (8, 13) der unter der Maske (5) angeordneten Bauelemente (10, 19) zugeführt wird, **dadurch gekennzeichnet,** daß alle Erwärmungsbereiche (8, 13) durch Bestrahlen mittels Laserstrahlen (4) erwärmt und die Bauelemente (10, 19) miteinander verbunden oder getrennt werden, wobei eine Relativbewegung zwischen einem oder mehreren Laserstrahlen und den Bauelementen (10, 19) durchgeführt wird.

2. Verfahren nach Anspruch 1, **dadurch gekennzeichnet,** daß alle Erwärmungsbereiche (8, 13) der Bauelemente (10, 19) gleichzeitig erwärmt und miteinander durch Bestrahlen mittels eines oder mehrerer im Querschnitt länglichen Laserstrahlen (4) mit einer Linienlänge, die mindestens der Gesamtlänge des Erwärmungsbereiches (14) entspricht, verbunden werden.

3. Verfahren nach Anspruch 1 oder 2, **dadurch gekennzeichnet,** daß die Relativbewegung zwischen dem Laserstrahl (2) und den Bauelementen (10, 19) durch eine schwenk- oder drehbare Strahlumlenkeinrichtung (15) erzeugt wird.

4. Verfahren nach Anspruch einem der vorangegangenen Ansprüche, **dadurch gekennzeichnet,** daß der Laserstrahl über eine Optik, vorzugsweise eine Zylinderlinse (16), telezentriert wird.

5. Verfahren nach einem der vorangegangenen Ansprüche, **dadurch gekennzeichnet,** daß mittels einer Zoom-Optik (31) unterschiedliche Laserlinienlängen erzeugt werden.

6. Verfahren nach einem der vorangegangenen Ansprüche, **dadurch gekennzeichnet,** daß entsprechend der maximalen Leistung der Laserquelle (1) zur Erwärmung des Erwärmungsbereichs auf die erforderliche Verbindungstemperatur die Taktzeit möglichst kurz gewählt wird.

7. Verfahren nach einem der vorangegangenen Ansprüche, **dadurch gekennzeichnet,** daß mehrere Laserpunkte (33) gleichzeitig auf die ausgenommenen Bereiche (6) fokussiert werden.

8. Verfahren nach einem der vorangegangenen Ansprüche, **dadurch gekennzeichnet,** daß eine Maske (5) mit Gruppen (14) von den Erwärmungsbereichen (8, 13) entsprechenden Ausnehmungen (6) für Bauelemente (10, 19) mit verschiedenen Abmessungen verwendet und die jeweils die zu verbindenden Bauelemente (10, 19) betreffenden Anschlußgruppen bestrahlt werden.

9. Vorrichtung zum selektiven Verbinden oder Trennen von mindestens zwei Bauelementen (10, 19) mittels Wärmestrahlen (4), wobei zwischen der Strahlenquelle (1) und den Bauelementen (10) eine Maske (5) aus einem strahlundurchlässigen Material angeordnet ist, bei der Bereiche (6) ausgenommen sind, durch die Wärmestrahlung auf selektierte Erwärmungsbereiche (8, 13) der unter der Maske (5) angeordneten Bauelemente (10, 19) gelangt, **gekennzeichnet durch** eine Laserquelle (1) oberhalb der Maske (5), wobei zur Relativbewegung zwischen der Laserquelle (1) und den Bauelementen (10, 19)
- entweder der Laserstrahl (2) über einen schwenk- oder drehbarer Spiegel (15) umgelenkt wird, der über der Maske (5) angeordnet und mittels eines Antriebs (18) betätigbar ist, oder die Laserquelle (1) an einem linearen Bewegungselement (28) angeordnet ist, das mittels eines Antriebs (27) parallel zur Maskenebene bewegbar ist, wobei in beiden Fällen die Bauelemente (10, 19) feststehen.

10. Vorrichtung nach Anspruch 9, **dadurch gekennzeichnet,** daß zusätzlich wahlweise die Bauelemente (10, 19) zusammen mit der Maske (5) bei feststehendem Laserstrahl (2) auf einem linearen Bewegungselement (30) angeordnet sind, das mittels eines Antriebs (31) senkrecht zum Laserstrahl (2) bewegbar ist.

11. Vorrichtung nach Anspruch 9 oder 10, **dadurch gekennzeichnet,** daß zwischen dem Spiegel (15) und der Maske (5) ein Optiksystem (16, 31, 32) zur Formung des Laserstrahls (4) angeordnet ist.

12. Vorrichtung nach Anspruch 11, **dadurch gekennzeichnet,** daß das Optiksystem eine Zoom-Optik (16, 31) zur Einstellung der Laserstrahllänge und/oder eine Optik (16, 32) zur Erzeugung mehrerer einzelner Laserpunkte (33) umfaßt.
